# EUROPEAN PATENT APPLICATION

(11) **EP 4 471 852 A1**
(43) Date of publication of application: **04.12.2024**
(21) Application number: 23923201.0
(22) Date of filing: 03.04.2023
(51) Int. Cl.: H01L 23/485

(54) **INTEGRATED PACKAGE DEVICE, MANUFACTURING METHOD THEREFOR AND STORAGE SYSTEM**

(71) Applicant: Yangtze Memory Technologies Co., Ltd., Wuhan Hubei 430000 (CN)
(72) Inventor: ZENG, Xinru, Wuhan, Hubei 430000 (CN); CHEN, Peng, Wuhan, Hubei 430000 (CN)
(74) Representative: Lippert Stachow Patentanwälte Rechtsanwälte
(86) International application number: PCT/CN2023/086020
(87) International publication number: WO 2024/207156

(57) **Abstract**

The present application discloses an integrated package device, a method of fabricating an integrated package device and a memory system. The integrated package device includes at least one package module, each package module including: a first sub-package module including a plurality of first electronic devices; a second sub-package module including a plurality of second electronic devices; a first re-distribution layer connected with first pads; and a second re-distribution layer connected with second pads.

## Description

### FIELD OF THE INVENTION

The present application relates to the field of semiconductor technologies, and in particular to an integrated package device, a fabrication method thereof and a memory system.

### BACKGROUND

With the development of chip technologies, various packaging techniques have been proposed, among which an existing packaging technique using chip stacking includes wiring and TSV processes. However, the wiring process may enlarge the footprint of the whole package due to the existence of bonding fingers, and the TSV process requires matching between chip designs and chip packaging, is difficult technically and has a relatively high cost. In recent years, fan-out packages have emerged and are expected to drive the development of chip stack packaging. However, in known fan-out package structures, there are problems in system structure of poor assembling efficiency and manner as well as poor physical protection.

### SUMMARY

### Technical Problem

An embodiment of the present application provides an integrated package device, a method of fabricating the same and a memory system that make a breakthrough in packaging efficiency and quantity of devices and provide effects of heat conducting and magnetic shielding.

### Technical Solution

In an aspect, an embodiment of the present application provides an integrated package device including at least one package module, each package module including:
a first sub-package module including a plurality of first electronic devices and a molding body encapsulating the plurality of first electronic devices, each of first electronic devices including a first pad on a side thereof;
a second sub-package module stacked on the side of the first sub-package module away from the first pad and including a plurality of second electronic devices and a second molding body encapsulating the plurality of second electronic devices, each of the second electronic devices including a second pad on a side thereof;
a first re-distribution layer located on the side of the first sub-package module away from the second sub-package module and connected with each of the first pads; and
a second re-distribution layer located on the side of the second sub-package module away from the first sub-package module and connected with each of the second pads.

Optionally, the package module further includes:
a through molding via (TMV) extending through the first molding body and the second molding body and connecting the first re-distribution layer and the second re-distribution layer.

Optionally, the integrated package device further includes a first bonding structure and a second bonding structure that are located on the first sub-package module and the second sub-package module respectively and are sandwiched therebetween, the first bonding structure and the second bonding structure bonding the first sub-package module and the second sub-package module together.

Optionally, the integrated package device further includes an external connection structure located on the side of the second re-distribution layer away from the second sub-package module and connected with the second re-distribution layer.

Optionally, the external connection structure includes tin ball array.

Optionally, the integrated package device further includes a protecting layer covering the side of the first re-distribution layer away from the first sub-package module.

Optionally, the integrated package device further includes an adhesive layer between the first sub-package module and the second sub-package module.

Optionally, the plurality of first electronic devices and/or the plurality of second electronic devices are stacked, in staircase, respectively in the direction, in which the first sub-package module and the second sub-package module are stacked, and the first pad of each of the first electronic devices and/or the second pad of each of the second electronic devices are/is not covered by any other first electronic device and/or any other second electronic device.

Optionally, the outer connecting surfaces of the first pads and the outer connecting surfaces of the second pads face the first re-distribution layer and the second re-distribution layer respectively, and the first sub-package module and/or the second sub-package module further include first conductive pillars and/or second conductive pillars respectively, which electrically connect the first re-distribution layer with part of the first pads and/or the second redistribution layer with part of the second pads respectively.

Optionally, the outer connecting surfaces of the first pads face away from the first re-distribution layer or the outer connecting surfaces of the second pads face away from the second re-distribution layer, and the package module further includes gold wires, through which the first pads are connected with the first re-distribution layer or the second pads are connected with the second re-distribution layer.

Optionally, the plurality of first electronic devices and the plurality of second electronic devices are arranged respectively in at least two columns in the lateral direction perpendicular to the direction, in which the first sub-package module and the second sub-package module are stacked; and the TMV is located on the outer side of one column of electronic devices away from the other column, and there is at least one TMV

Optionally, the plurality of first electronic devices and the plurality of second electronic devices are arranged respectively in at least two columns in the lateral direction perpendicular to the direction, in which the first sub-package module and the second sub-package module are stacked; and the TMV is located between the two columns of electronic devices, and there is at least one TMV

Optionally, the integrated package device further includes a plurality of the package module, wherein the plurality of package modules are stacked in the direction, in which the first sub-package module and the second sub-package module are stacked; the external connection structure on one of any two adjacent package modules is connected with the first re-distribution layer of the other of the two adjacent package modules; and the integrated package device further includes a protecting layer covering the first re-distribution layer of the package module outermost in the vertical direction.

Optionally, the package module further includes an external connection structure that is located on the side of the second re-distribution layer away from the second electronic devices and connected with the second re-distribution layer; and the integrated package device further includes:
a plurality of the package module that are stacked in the direction, in which the first sub-package module and the second sub-package module are stacked, and wherein
the external connection structure on one of any two adjacent package modules is connected with the first re-distribution layer of the other of the two adjacent package modules;
the integrated package device further includes a protecting layer covering the first re-distribution layer of the package module outermost in the vertical direction; and
the TMVs in the plurality of package modules are aligned or misaligned in the vertical direction.

In another aspect, an embodiment of the present application also provides a method of fabricating an integrated package device, the method including:
providing a first sub-package module and a second sub-package module, the first sub-package module including a plurality of first electronic devices and a first molding body encapsulating the plurality of first electronic devices, each of the first electronic devices including a first pad on a side thereof, and the second sub-package module being on the side of the first sub-package module away from the first pad, and comprising a plurality of second electronic devices and a second molding body encapsulating the plurality of second electronic devices, each of the second electronic devices including a second pad on a side thereof;
stacking the first sub-package module and the second sub-package module;
forming a first re-distribution layer located on the side of the first sub-package module away from the second sub-package module and connected with the first pads; and
forming a second re-distribution layer located on the side of the second sub-package module away from the first sub-package module and connected with the second pads.

Optionally, forming the second re-distribution layer connected with the second pads further includes forming a through molding via (TMV) that extends through the first molding body and the second molding body and connects the first re-distribution layer and the second re-distribution layer; and the second re-distribution layer is connected with the TMV

Optionally, the fabrication method further includes: forming an external connection structure that is on the side of the second re-distribution layer away from the second sub-package module and connected with the second re-distribution layer.

Optionally, providing the first sub-package module and the second sub-package module includes:
arranging the plurality of first electronic devices and the plurality of second electronic devices on a first temporary adhesive layer and a second temporary adhesive layer respectively with the outer connecting surfaces of the first pads of the first electronic devices facing respectively one and the same side as the outer connecting surfaces of the second pads of the second electronic devices facing one and the same side;
disposing a first carrier and a second carrier on the side of the plurality of first electronic devices and the side of the plurality of second electronic devices away from the first temporary adhesive layer and the second temporary adhesive layer respectively, the first carrier and the second carrier having temporary bonding films facing the plurality of first electronic devices and the plurality of second electronic devices respectively, and the outer connecting surfaces of the first pads and the outer connecting surfaces of the second pads facing the first carrier and the second carrier or facing away from the first carrier and the second carrier respectively; and
removing the first temporary adhesive layer and the second temporary adhesive layer and forming the first molding body and the second molding body on the first carrier and the second carrier respectively.

Optionally, the fabrication method further includes: before disposing the first carrier and the second carrier, disposing first conductive pillars and second conductive pillars on part of the first pads and part of the second pads respectively.

Optionally, stacking the first sub-package module and the second sub-package module further includes: disposing an adhesive layer between the first sub-package module and the second sub-package module.

Optionally, stacking the first sub-package module and the second sub-package module further includes: disposing a first bonding structure and a second bonding structure on the first sub-package module and the second sub-package module respectively.

Optionally, the fabrication method further includes: forming a protecting layer on the side of the first re-distribution layer away from the first sub-package module to cover the first re-distribution layer.

Optionally, the fabricated method further includes:
during stacking of the first sub-package module and the second sub-package module, placing the side of the first sub-package module and the side of the second sub-package module away from the first carrier and the second carrier respectively close to each other with the first carrier and the second carrier located on the two outer sides of the combination of the first sub-package module and the second sub-package module; and
removing the first carrier and the second carrier before forming the first re-distribution layer and the second re-distribution layer.

Optionally, the fabrication method further includes: providing a plurality of package modules; stacking the plurality of package modules in the direction, in which the first sub-package module and the second sub-package module are stacked; and connecting the external connection structure on one of any two adjacent package modules with the first re-distribution layer of the other of the two adjacent package modules.

Optionally, stacking the plurality of package modules in the direction, in which the first sub-package module and the second sub-package module are stacked, further includes: forming a protecting layer covering the first re-distribution layer of the package module outermost in the vertical direction.

In yet another aspect, an embodiment of the present application provides a memory system, the memory system including:
any one of the integrated package devices described above,
wherein at least one of the first electronic devices and/or at least one of the second electronic devices in the integrated package device include/includes a memory device and at least any other one of the first electronic devices and/or at least any other one of the second electronic devices include/includes a controller used to control operations of the memory device.

### Beneficial Effects

Using the integrated package device, the method of fabricating an integrated package device and the memory system disclosed by embodiments of the present application, not only a high number of semiconductor dies or electronic devices can be accommodated, but also the packaging density can be increased by taking vertical stack packaging scheme; meanwhile, the package body can have a system structure with electromagnetic shielding and the whole package body can have a relatively high proportion of metal; and meanwhile the dies may be disposed back to back and have thermally conductive adhesive films/bonding films therebetween, so that the whole structure has a good effect of heat dissipation. By utilizing RDLs instead of conventional gold wiring, the overall wiring pitch may be reduced, the transmission speed of signals can be increased, the high-frequency performance may be improved, and a substantially complete function may be realized to achieve a system in package (SiP). Furthermore, using the modular packaging solution disclosed by embodiments of the present application, a high stack structure can be achieved, the difficulty of processing ultra-thin chips for a high stack package having a high capacity may be reduced to facilitate mass production and packages of different capacities may be processed flexibly due to the infinite possibilities of stacking, so that the market demands can be met and the processing yield of packages can be beneficially improved.

### BRIEF DESCRIPTION OF ACCOMPANYING DRAWINGS

In order to illustrate the technical solutions in embodiments or in the prior art more clearly, drawings needed in the description of the embodiments or the prior art will be briefly introduced. Apparently, drawings in the following description represent only some embodiments of the present application and, in light of them, other drawings can be figured out by those of ordinary skills in the art without any creative works.
Figs. 1a to 1f are cross-sectional structure diagrams of various package modules in an integrated package device provided by embodiments of the present application;
Figs. 2a to 2d are cross-sectional structure diagrams of various combinations of stacked package modules in an integrated package device provided by embodiments of the present application and in particular Fig. 2d is a cross-sectional structure block diagram of an integrated package device as a memory system;
Fig. 3 is a flow chart of a method of fabricating an integrated package device provided in an embodiment of the present application;
Figs. 4a to 4j are cross-sectional structure diagrams corresponding to the main steps of fabricating a package module in a method of fabricating an integrated package device provided in an embodiment of the present application;
Fig. 5 is a representative cross-sectional structure diagram of a plurality of package modules during stacking in a method of fabricating an integrated package device in an embodiment of the present application; and
Figs. 6a and 6b are cross-sectional structure diagrams illustrating a combination of sub-package modules in a method of fabricating an integrated package device in an embodiment of the present application.

### DETAILED DESCRIPTION

Specific details of structures and functions disclosed herein are only representative and used for the purpose of describing exemplary embodiments of the present application. However, the present application may be specifically implemented in many alternative forms and should not be construed to be limited by the embodiments described herein.

In the description of the present application, it is understood that orientation and position relationships indicated by terms "center", "lateral", "upper", "lower", "left", "right", "vertical", "horizontal", "top", "bottom", "inner", "outer" and the like are those based on the drawings and only for the purpose of describing and simplifying the description. There is no indication or implication that the devices or elements referred to must have any particular orientations and positions, or be constructed or operated in any particular orientations and positions. As a result, they should not be understood as limitation for the present application. Moreover, the terms "first", "second" etc. are only used for the purpose of description and should not be understood to indicate or imply relative importance or to designate the number of the referenced technical features implicitly. Therefore, a feature qualified by "first" or "second" may include one or more instances of the feature explicitly or implicitly. In the description of the present application, "a plurality of" means two or more unless otherwise specified. Moreover, the term "include", "comprise" and variations thereof are intended to cover the meaning of "include or comprise non-exclusively".

Furthermore, when the same type of devices are qualified by the terms "first" and "second", it is only intended to distinguish different devices of the same type and express relative positions instead of any sequence or constancy. That is to say, the terms "first" and "second" are exchangeable and any one of the same type of devices that is referred to as "first" may also be referred to as "second".

In the description of the present application, it is to be noted that terms "interconnect" and "connect" should be explained broadly. They may include, for example, fixed connection, removable connection or integral connection; mechanical connection or electrical connection; direct interconnection or interconnection with intermediate medium; or inner communication of two elements, unless otherwise specified or limited expressly. The specific meaning of the above-mentioned terms in the present application will be understood by those of ordinary skill in the art depending on specific circumstances.

Terms used herein are only for the purpose of describing specific embodiments without any intention of limiting them. Singular forms used herein such as "a" and "an" are also intended to include plural forms, unless otherwise noted expressly in the context. It is also understood that terms "include" and/or "comprise" used herein designate existence of the stated features, integers, steps, operations, elements and/or assemblies without excluding existence or addition of one or more other features, integers, steps, operations, elements, assemblies and/or any combination thereof.

Fan-out wafer level packaging (FOWLP) is a new method of integrating a plurality of dies obtained from heterogeneous fabrication processes into one compact package. Due to the demands for apparatuses with a low profile and a higher number of inputs/outputs, fan-out wafer level packages are drawing increasing attention. With the development of FOWLP, single-chip applications have evolved into multi-chip package (MCP) applications, 3D package on package (PoP) applications and the like to achieve a higher level of integration of I/O chips.

FOWLP makes full use of re-distribution layers (RDLs) for connection so as to maximize interconnection density. Conventional WLP packages are usually in Fan-in configurations and used for ICs with a low number of pins. When the area of a chip decreases, the number of pins that can be accommodated by the chip also decrease, and as the result FOWLP packages in a spreading configurations have been developed to utilize RDLs fully for making connections outside the chip, increasing the number of pins. When each die is embedded in an epoxy molding compound (EMC), the gaps between dies each has an additional I/O connecting point so as to increase the I/O number, improve silicon utilization, maximize interconnection density and achieve high-bandwidth transmissions of data.

FOWLP can lower package cost and package thickness. In contrast to fan-in packaging techniques, FOWLP has the advantages of reduced package thickness, scalability (increased I/O number), improved electrical performance, good thermal performance and processes without any base plate. Fan-out WLP is similar to conventional ball grid array (BGA) packaging in structure, but needs no expensive substrate process.

Based on the demands for versatile and miniaturized system products, integrated circuit packages enter an era of 3D stacking packages. The era of 3D stacking packages is characterized by (1) evolvement from package assemblies to package systems, (2) development from single-chip applications to multiple-chip applications, and (3) development from in-plane packages (MCM) to 3D packages. However, until now there are no effective and efficient package designs that enable simple operations of 3D packaging and adapt to various combinations, especially in designing of memory chips and memory systems. Therefore, the present application utilizes chip size packages (CSPs) and build-up multilayer base plates technique in combination with flip connection, connection through vias, Package on Package (PoP) techniques and the like as well as an ingenious design to provide an integrated package device that provides convenience and adapts to various system packages, especially those including memories. The integrated package device can integrate chips of various functions, including a processor, a memory or any other functional chips, into one package to realize a substantially complete function and form a system in a package (SiP).

Hereafter, in some embodiments, the integrated package device, the fabrication method thereof and the memory system provided by the present application will be illustrated.

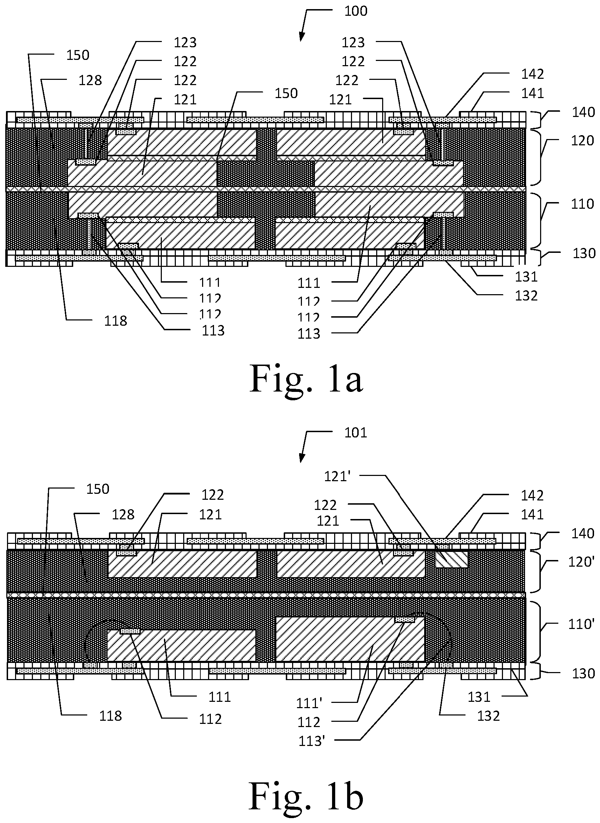

At first, as shown in Figs. 1a to 1f, an integrated package device, especially the package modules that can facilitate stack packaging and in turn formation of the integrated package device, in accordance with some embodiments of the present application is illustrated.

First of all, the integrated package device in accordance with some embodiments of the present application can be a basic one. As shown in Fig. 1a, the integrated package device illustrated in an embodiment of the present application includes at least one package module 100, the package module 100 mainly including a first sub-package module 110, a second sub-package module 120, a first re-distribution layer 130 and a second re-distribution layer 140, wherein the first sub-package module 110 includes a plurality of first electronic devices 111 and a first molding body 118 encapsulating the plurality of first electronic devices, each of the first electronic devices 111 including a first pad 112 on a side thereof. The second sub-package module 120 is stacked on the side of the first sub-package module 110 away from the first pads 112 and includes a plurality of second electronic devices 121 and a second molding body 128 encapsulating the plurality of second electronic devices, each of the second electronic devices 121 including a second pad 122 on a side thereof. The first re-distribution layer 130 is on the side of the first sub-package module 110 away from the second sub-package module 120 and connected with the first pads 112. The second re-distribution layer 140 is on the side of the second sub-package module 120 away from the first sub-package module 110 and connected with the second pads 122.

Specifically, the first electronic devices 111 and the second electronic devices 121 may include any active devices or passive components and can be collectively referred to as the first or second electronic devices respectively. Common passive components are mainly resistors, inductors, capacitors and the like, characterized by the capability of operating without any power source in a circuit when signals are present, and can be classified into a circuit type and a connection type according to their functions in a circuit. Therefore, the first electronic devices 111 and/or the second electronic devices 121 may include, for example, diodes, resistors, resistor networks, capacitors, inductors, transformers, relays, keys, beepers, speakers, switches or any other devices of the circuit type.

Active devices are main devices of an electronic circuit and can be classified into the type of discrete devices and the type of integrated circuits according to their physical structures, circuit functions and engineering parameters. Therefore, the first electronic devices 111 and/or the second electronic devices 121 may include, for example, discrete devices such as bipolar transistors (BJT, briefly known as transistors), field effective transistors, thyristors and semiconductor resistors and capacitors (those fabricated by integration processes and used in integrated circuits); or analog integrated circuit devices such as integrated operation amplifiers, comparators, logarithmic amplifiers and exponential amplifiers, analog multipliers/dividers, analog switches, phase lock loops (PLLs), voltage regulators, reference sources, wave-form generators, power amplifiers, power management circuits and the like; or digital integrated circuit devices such as basic logic gate circuits, flip-flops, registers, decoders, data comparators, drivers, counters, shaping circuits, PLDs, microprocessors (MPUs), microcontrollers (MCUs), digital signal processors (DSPs) and the like.

The plurality of first electronic devices 111 may be the same as or different from each other, and so may the plurality of second electronic devices 121. For example, as shown in the embodiment of Fig. 1a, the first electronic devices 111 in the first sub-package module 110 may be the same as each other and so may the second electronic devices 121 in the second sub-package module 120. They can be, but not limited to, semiconductor chips with storage functions. Any types of chips can be chosen for the first electronic devices 111 and the second electronic devices 121 as required.

As an optional embodiment of the combination of the first electronic devices 111 and the second electronic devices 121, Fig. 1b illustrates another example package module 101 of the integrated package device in accordance with an embodiment of the present application. The package module 101 may be different from the package module 100 in type, number and arrangement of electronic devices. In the embodiment shown in Fig. 1b, the first sub-package module 110' also includes a plurality of first electronic devices, however the plurality of first electronic devices include a first electronic device 111 and a first electronic device 111' different from the first electronic device 111. The first electronic device 111 may be, for example, a semiconductor memory chip/die such as a DRAM, a NAND, an NOR, an FeRAM, a RRAM or a PCRAM, while the first electronic device 111' may be, for example, a controller, a power management circuit device or the like. The second package module 120' also includes a plurality of second electronic devices, however the plurality of second electronic devices include a second electronic device 121 and a second electronic device 121' different from the second electronic device 121. The second electronic device 121 may be, for example, a semiconductor memory chip/die such as a NAND, an NOR, an FeRAM, a RRAM, a PCRAM or a DRAM, while the second electronic device 121' may be, for example, a passive device such as an inductor or a semiconductor discrete device. Hereinafter, even though the first electronic devices 111/111' may be the same as or different from each other and so may the second electronic devices 121/121' as illustrated above, the first electronic devices 111 and the second electronic devices 121 may be taken as a representative to facilitate description.

By the way, both the first electronic devices 111 and the second electronic devices 121 are electronic devices each having a substrate and electronic components on the substrate. The electronic components may include 2D units, 3D memory units and/or any other suitable components. Herein, the term "3D memory unit" means a semiconductor device having memory cell transistor strings (also referred to as "memory strings") each extending in the direction perpendicular to the direction of chip thickness.

Furthermore and specifically, as shown in Fig. 1a, the first electronic devices 111 each has at least one first pad 112 on a side thereof and/or the second electronic devices 121 each has at least one second pad 122 on a side thereof, the first pad 112 and the second pad 121 each acting as a component of a signal transmitting path between the corresponding electronic device and an external device such as a signal source or a power source. For its simplicity and clarity, Fig. 1a only shows that each first electronic device 111 has one first pad 112 and/or each second electronic device 121 has one second pad 122, however in fact each first electronic device 111 may have a plurality of first pads 112 and/or each second electronic device 121 may have a plurality of second pads 122. Each first pad 112 and/or each second pad 122 may include at least one conductive material, such as, but not limited to, metal and/or a transparent conductive material.

Furthermore, in Fig. 1a, the first sub-package module 110 and the second sub-package module 120 respectively comprise two columns of four first electronic devices 111 and second electronic devices 121 (only two first electronic devices are labeled and not all of them are labeled) stacked sequentially in the longitudinal direction of the figure, and in the transverse direction perpendicular to the stacking direction in two columns on the left and right. That is to say, the plurality of first electronic devices 111 and/or the plurality of second electronic devices 121 are stacked, in staircase, respectively in the directions, in which the first sub-package module 110 and/or the second sub-package module 120 are stacked, so that the first pad 112 of each first electronic device 111 and/or the second pad 122 of each second electronic device 121 will not be covered by any other first electronic device 111 and/or any other second electronic device 121. However, the present application is not limited to this. For example, when any two first/second electronic devices stacked one on top of the other are bonded and electrically connected through a bonding structure formed using a bonding adhesive layer, the two electronic devices are not necessarily stacked in staircase to misalign their first/second pads. For example, in the embodiment shown in Fig. 1b, the first electronic devices 111 may be arranged in only one tier, and/or so may the second electronic devices 121. In this case, it is unnecessary to take the stacking manner and design of mutual adhesion into account.

In the embodiment of Fig. 1a, the plurality of first electronic devices 111 and/or second electronic devices 121 stacked on top of each other may be adhered to each other through die attachment films (DAFs) or thermally conductive adhesive films 150, may be joined through adhesive layers and may, of course be bonded and electrically connected through the above-described bonding adhesive layers. The present application is not limited to this. The die attachment films/thermally conductive adhesive films 150 may be disposed between opposite stacking surfaces of the first electronic devices 111 and/or the second electronic devices 121, which, however, means no limitation.

Likewise, the first sub-package module 110 and the second sub-package module 120 may be adhered to each other through a DAF 150 or any other adhesive film, may be joined through an adhesive layer and may, of course be bonded and electrically connected through the above-described bonding adhesive layer, which means no limitation. The DAF 150 may be respectively disposed on the opposite stacking surfaces of the first sub-package module 110 and the second sub-package module 120.

Furthermore and specifically, as shown in Fig. 1a, the first sub-package module 110 and/or the second sub-package module 120 may also include vertical first conductive pillars 113 and/or second conductive pillars 123 respectively, which electrically connect the first re-distribution layer 130 with part of the first pads 112 and/or the second redistribution layer 140 with part of the second pads 122 respectively. The first conductive pillars 113 and second conductive pillars 123 may include at least one conductive material, such as, but not limited to, gold, copper, aluminum, silver and/or any other suitable metal. Due to the use of the vertical conductive pillars, the lateral dimensions of the chip package structure 300 may be further reduced.

In some variations of the embodiment, as shown in Fig. 1b, the conductive layer 132 or 142 in the first re-distribution layer 130 or the second re-distribution layer 140 may also be electrically connected with the first pads 112 or the second pads 122 respectively through gold wires 113'.

That is to say, the first re-distribution layer 130 and the second re-distribution layer 140 may be electrically connected with the first pads 112 of the first electronic devices 111 and the second pads 122 of the second electronic devices 121 respectively through the conductive pillars or gold wires. Specifically, as shown in Fig. 1a, when the outer connecting surfaces of the first pads 112 and the outer connecting surfaces of the second pads 122 face the first re-distribution layer 130 and the second re-distribution layer 140 respectively, the first sub-package module 110 and/or the second sub-package module 120 may include the first conductive pillars 113 and/or second conductive pillars 123 respectively, which electrically connect the first re-distribution layer 130 with part of the first pads 112 and/or the second redistribution layer 140 with part of the second pads 122 respectively. Additionally, as shown in Fig. 1b, when the outer connecting surfaces of the first pads 112 are disposed to face away from the first re-distribution layer 130 or the outer connecting surfaces of the second pads 122 are disposed to face away from the second re-distribution layer 140, the first sub-package module 110 or the second sub-package module 120 in the package module 101 may include gold wires, through which the first pads 112 are connected with the first re-distribution layer 130 or the second pads 122 are connected with the second re-distribution layer 140.

Furthermore and specifically, as shown in Figs. 1a and 1b, the first sub-package module 110/110' and the second sub-package module 120/120' include the first molding body 118 and the second molding body 128 respectively, which encapsulate the plurality of first electronic devices 111 and the plurality of second electronic devices 121 to form the sub-package modules respectively and expose the first pads 112 and the second pads 122 as well as the first conductive pillars 113 and the second conductive pillars 123 or the gold wires 113' respectively. The first molding body 118 and the second molding body 128 may protect the plurality of first electronic devices 111 and the plurality of second electronic devices 121 to reduce their physical/chemical damages (such as those from oxidization and moisture) respectively and may include epoxy resin and/or any other suitable molding compound, including epoxy resin, phenolic resin, a catalytic agent, micro powder of silicon dioxide or the like.

Moreover, still as shown in Figs. 1a and 1b, the first re-distribution layer 130 is on the side of the first sub-package module 110/110' away from the second sub-package module 120/120' and connected with the first pads 112; and the second re-distribution layer 140 is on the side of the second sub-package module 120/120' away from the first sub-package module 110/110' and connected with the second pads 122.

The first re-distribution layer 130 may include at least one conductive layer 132 and at least one insulating layer 131, wherein each conductive layer 132 may include metal, any other suitable conductive material or any combination thereof, and each insulating layer 131 may include an organic or inorganic material, such as silicon oxide, silicon nitride, silicon oxynitride, any other suitable insulating material or any combination thereof. Likewise, the second re-distribution layer 140 may include at least one conductive layer 142 and at least one insulating layer 141, wherein each conductive layer 142 may include metal, any other suitable conductive material or any combination thereof, and each insulating layer 141 may include, for example, silicon oxide, silicon nitride, silicon oxynitride, any other suitable insulating material or any combination thereof. The number of the conductive layer(s) 132/142 and the number of the insulating layer(s) 131/141 in the first and second re-distribution layer 130 and 140 may be determined depending on practical designs and for convenience only one conductive layer 132/142 is shown, which, however, means no limitation.

Still as shown in Fig. 1a, the insulating layers 131 and 141 of the first and second re-distribution layers 130 and 140 each have a plurality of openings (not labeled) to expose a plurality of portions of the corresponding conductive layers 132 and 142 for external connection.

As a summary of the description above, it can be appreciated that the first electronic devices 111/111' in the first sub-package module 110/110' and the second electronic devices 121/121' in the second sub-package module 120/120' may be any types of electronic devices and can be arranged and connected side by side or in stack and that the connecting components between the electronic devices and the first re-distribution layer 130 or the second redistribution layer 140 may also be varied. Therefore, in some further embodiments hereafter, for convenience of description, the combination of the first electronic devices 111/111' in the first sub-package module 110/110' and the second electronic devices 121/121' in the sub-package module 120/120' and the connections between the electronic devices and the first re-distribution layer 130 or the second redistribution layer 140 will be described with reference to the combination in Fig. 1a that is taken as an representative.

Through the package module 100/101 described above, the main members of the package stack structure as the base of the integrated package device disclosed by an embodiment of the present application are provided. Such package module, as an integrated package device, not only accommodates a high number of semiconductor dies or devices, but also increases packaging density by taking vertical stack packaging. Meanwhile, the package body can have a system structure with electromagnetic shielding and the whole package body can have a relatively high proportion of metal. The dies may be disposed back to back and have thermally conductive films/bonding films therebetween. As a result, the whole structure has a good effect of heat dissipation. By utilizing RDLs instead of conventional gold wiring, the overall wiring pitch may be reduced by 40% or more, the transmission speed of signals can be increased, the high-frequency performance may be improved, and a substantially complete function may be realized to achieve a system in package (SiP). Furthermore, circuit scalability can be enabled by electronic devices by means of the internal or external connection components of the package module. When such a package module is used to complete a high stack structure in a modularized packaging process described below, the difficulty of package processing ultra-thin chips for a high stack package having a high capacity may be reduced to facilitate mass production and packages of different capacities may be processed flexibly due to the infinite possibilities of stacking, so as to meet the market demands and beneficially improve the processing yield of packages.

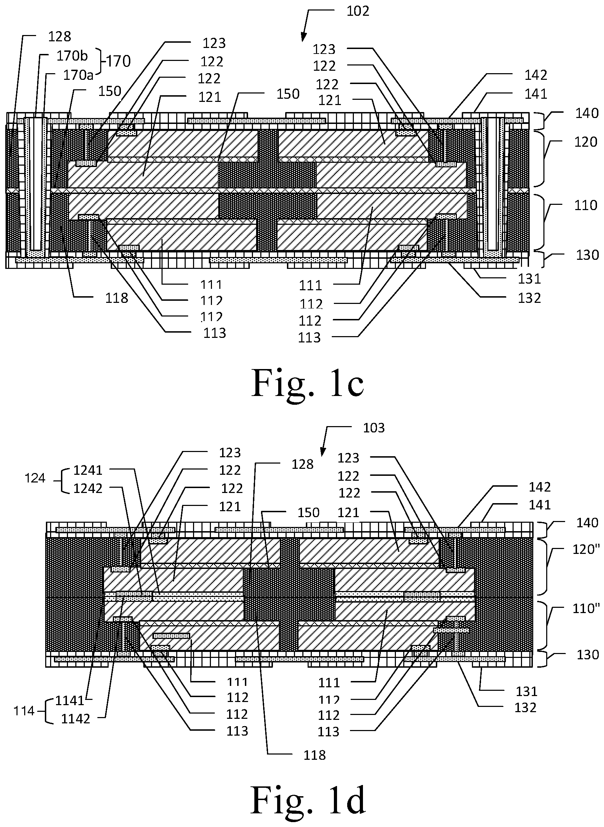

Hereafter, with further reference to Figs. 1c and 1d, some other embodiments will be disclosed in accordance with the present application.

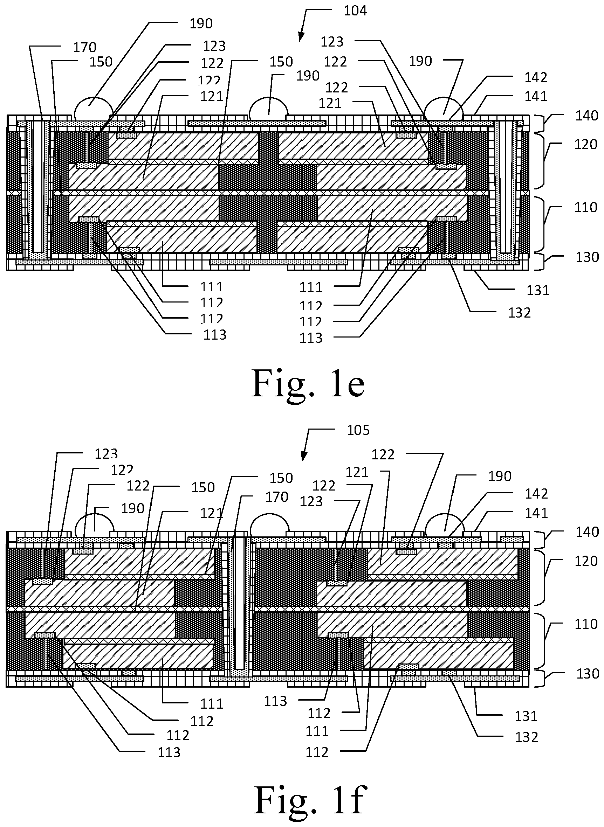

As shown in Fig. 1c, the package module 102, as an integrated package device in accordance with an embodiment of the present application, is based on the package module 100 as shown in Fig. 1a with through molding vias (TMVs) 170 added. The same components in the package module 102 as those in the package module 100 will not be repeated here and only the difference between the two package modules will be explained. Each through molding via 170 as shown extends through the first molding body 118 and the second molding body 128 and connects the first re-distribution layer 130 and the second re-distribution layer 140. Also, as shown in Fig. 1c, a plurality of first electronic devices 111 and a plurality of second electronic devices 121 are respectively arranged in at least two columns disposed in the lateral direction perpendicular to the direction, in which the first sub-package module 110 and the second sub-package module 120 are stacked; and each through molding via 170 may be disposed on the outer side of one column of electronic devices away from the other column, and there may be at least one through molding via. However, in some embodiments, as shown in Fig. 1f below, each through molding via 170 may be disposed between two columns of electronic devices and there may be at least one through molding via 170.

Specifically, each through molding via 170 may include an insulating layer (not labeled) and a metal layer 170a formed on the inner sidewall of an opening through the first molding body 118 and the second molding body 128 and an insulator 170b filled within the metal layer 170a, the metal layer 170a connecting the conductive layers 132 and 142 in the first re-distribution layer 130 and the second re-distribution layer 140 to electrically connect the first re-distribution layer 130 and the second re-distribution layer 140 outside the first sub-package module 110 and the second sub-package module 120 respectively and thus diversifying circuit connections between electronic devices of the package module 102.

Using 3D interconnection techniques, like the through molding vias (TMVs) 170, in contrast to wire bonding, shorter interconnection paths, lower resistance and inductance and more efficient transmissions of signals and power can be achieved, so that signal transmissions in the whole package module are improved or sped up, high-frequency performance of the product is improved, the number of the stacked dies is not limited, fabrication and design processes are easy, and costs are further reduced to earn cost efficiency.

Furthermore, in accordance with some embodiments of the present application, as shown in Fig. 1d, a package module 103 is disclosed as an integrated package device, which is similar to the package module 100 as shown in Fig. 1a, but is different from it in that, instead of using the DAF 150, a first bonding structure 114 and a second bonding structure 124 are included on the bonding surfaces of the electronic devices on the bonding side of the first sub-package module 110" and the bonding side of the second sub-package module 120" respectively to bond the first sub-package module 110" and the second sub-package module 120" together and achieve circuit connections.

Specifically, the first bonding structure 114 and the second bonding structure 124 may have the same structure and each have at least one bonding insulating layer 1141/1241 and at least one bonding contact 1142/1242 extending longitudinally through the bonding insulating layer 1141/1241. The bonding contacts 1142 and 1242 connect the circuit interconnection layers (not shown) in the first electronic devices 111 and the second electronic devices 121 to achieve mechanical and electrical connections between the first sub-package module 110" and the second sub-package module 120" in the package module 103 directly through the first bonding structure 114 and the second bonding structure 124. The material of each bonding insulating layer 1141/1241 may include, for example, silicon oxide, silicon nitride, silicon oxynitride, any other suitable insulating material or any combination thereof and the material of each bonding contact 1142/1242 may include at least one conductive material, such as gold, copper, aluminum, silver and/or any other suitable metal, which means no limitation. Specific bonding techniques can be referred to disclosure in the art and will not be repeated here.

By disposing the first bonding structure 114 and the second bonding structure 124 to replace the above-mentioned TMVs, the fabrication processes for the TMVs can be omitted, however the bonding structures can be disposed in addition to the TMVs to achieve the function equivalent to that obtained by the above-mentioned TMVs 170. By the way, as previously mentioned, a plurality of first electronic devices 111 in the first sub-package module 110/110" or a plurality of second electronic devices 121 in the second sub-package module 120/120" may be mechanically and electrically connected through the above-mentioned bonding structures to achieve more ways of conductive connection.

As another summary of the description above, in contrast to the package module 100/101, the above-described package module 102/103 has additional TMVs or bonding structures and thus not only constitutes the main member of the package stack structure as the base of an integrated package device but also provides more possibilities of circuit connection for flexibility of application, so that combinations of package modules can be used more flexibly in any subsequent package stack structure.

Hereafter, with further reference to Figs. 1e and 1f, basic package modules of an integrated package device in accordance with some embodiments of the present application will be disclosed.

As shown in Fig. 1e, a package module 104 is disclosed as an integrated package device. Based on the package module 102 as shown in Fig. 1c, the package module 104 has additional external connection structures 190 that are on the side of the second re-distribution layer 140 away from the second sub-package module 120 and connected with the second re-distribution layer 140.

As shown in Fig. 1f, a package module 105 is also disclosed as an integrated package device. Similar to the above-mentioned package module 104, the package module 105 also has additional external connection structures 190 that are on the side of the second re-distribution layer 140 away from the second sub-package module 120 and connected with the second re-distribution layer 140. But the package module 105 is different from the package module 104 in the position of each TMV 170. That is to say, in the package module 105, a plurality of first electronic devices 111 and a plurality of second electronic devices 121 are arranged respectively in at least two columns disposed in the lateral direction perpendicular to the direction, in which the first sub-package module 110 and the second sub-package module 120 are stacked; but the TMV 170 is not disposed on the outer side of one column of electronic devices away from the other column but between two columns of electronic devices, and there may be at least one TMV 170.

Specifically, the external connection structure 190 may include, but not limited to, an array of tin balls and may also include, for example, tin paste, conductive glue or bonding contacts. The tin balls are disposed in a plurality of openings (not labeled) that are in the above-mentioned insulating layer(s) 141 and face outside, and electrically connected with the exposed portions of the conductive layer 142. Using the tin balls of the external connection structure 190 as signal input/output terminals, the signals from an external device may be input into the package module 104/105 and the signals from the package module 104/105 may be output to the external device.

Furthermore, in the embodiments as shown in Figs. 1e and 1f, although the external connection structure 190 is described to be on the side of the second re-distribution layer 140 away from the second sub-package module 120 and connected with the second re-distribution layer 140, it should be understood that the description is only for convenience of illustration and in practice an external connection structure 190 can also be located on the side of the first re-distribution layer 130 away from the first sub-package module 110 and connected with the first re-distribution layer 130. Therefore, it should be appreciated that the term "first" or "second" herein implies no meaning of "upper" or "lower" and can be exchangeable without departing from the scope of the present application as long as a relative relationship is met.

Using the package module 104/105 with the additional external connection structure 190 in the integrated package device disclosed in embodiments of the present application, a plurality of package modules can be stacked and their external connections can be achieved by directly using the package module 104/105 as a unit. However, it should be understood here that even though there is only the structure of the above-mentioned package module 102/103 for now, a plurality of package modules can of course be stacked and externally connected, because the external connection structure 190 is a component that may be added when apparatus mounting is performed or a plurality of package modules are stacked by a downstream manufacturer. Therefore, the integrated package device disclosed in accordance with the spirit of the present application may be or include any one of the above-described package modules 100, 101, 102, 103, 104 and 105.

Hereafter, in accordance with embodiments of the present application, various integrated package devices that can be obtained using various stacking combinations utilizing any of the above-described various package modules 100, 101, 102, 103, 104 and 105 will be described. That is to say, based on the package module 100, 101, 102, 103, 104, 105, the integrated package device disclosed by embodiments of the present application may include one or more package modules.

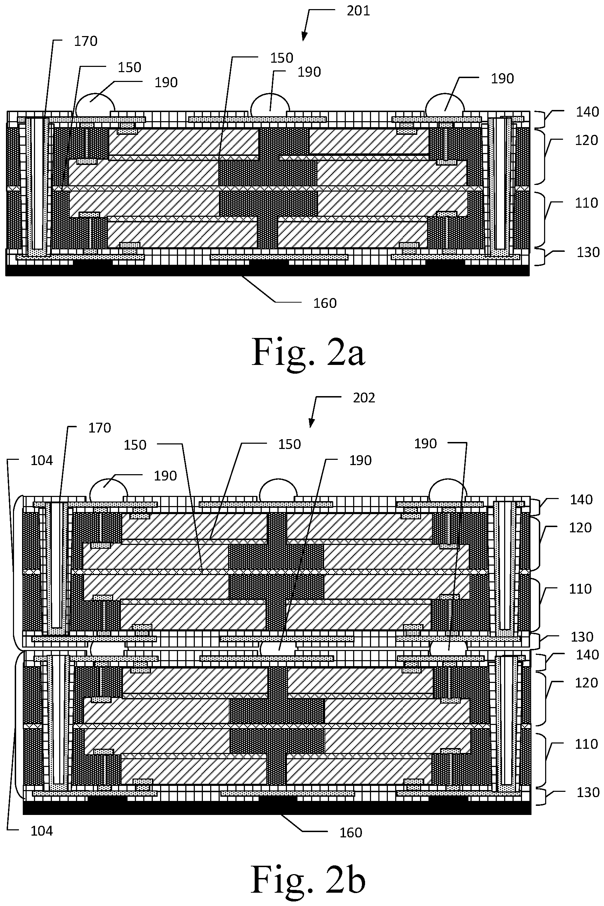

At first, as shown in Fig. 2a, an embodiment is illustrated, in which an integrated package device disclosed by the present application is made of one package module. As shown in Fig. 2a, the integrated package device 201 includes the package module 105 as shown in Fig. 1e and a protecting layer 160 covering the first re-distribution layer 130 on the side away from the first sub-package module 110.

Specifically, the material of the protecting layer 160 may be the same as that of the above-mentioned first/second molding body 118/128 and may include epoxy resin and/or any other suitable molding compound such as epoxy resin, phenolic resin, a catalytic agent and micro powder of silicon dioxide, which means no limitation. The protecting layer 160 may protect the first re-distribution layer 130 from being damaged physically and/or chemically by, for example, oxidization and moisture.

In the integrated package device 201 as shown in Fig. 2a, as a vertical stack packaging scheme is employed, the following effects can also be achieved: accommodating a high number of semiconductor dies or devices, increasing the packaging density, and the package body having an electromagnetic shielding. And the whole package body has a high proportion of metal, and dies are disposed back to back and have thermally conductive adhesive/bonding films therebetween to enable better effect of heat dissipation for the whole structure.

Subsequently, as shown in Fig. 2b, an embodiment is illustrated, in which an integrated package device disclosed by embodiments of the present application is made of two package modules.

As shown in Fig. 2b, the integrated package device disclosed in accordance with the embodiment of the present application includes multiple instances of the package modules; the multiple package modules can be stacked in the direction, in which the first sub-package module and the second sub-package module are stacked; the external connection structure on one of any two adjacent package modules is connected with the first re-distribution layer of the other of the two adjacent package modules; and the integrated package device further includes a protecting layer covering the first re-distribution layer of the package module outermost in the vertical direction.

Specifically, the integrated package device 202 as shown in Fig. 2b includes two package modules 104 (each as shown in Fig. 1e) stacked one on top of the other in the direction, in which the first sub-package module 110 and the second sub-package module 120 are stacked. The tin balls (external connection structure) 190 of the lower package module 104 act as members connected with the first re-distribution layer 130 in the upper package module 104. The integrated package device 202 further includes a protecting layer 160 covering the first re-distribution layer 130 of the package module 104 outermost in the vertical direction, i.e., being located at the bottom surface of the lower package module 104.

Using the integrated package device 202 as shown in Fig. 2b, the difficulty of processing ultra-thin chips/dies for a high stack package having a high capacity may be reduced to facilitate mass production and packages of different capacities may be processed flexibly due to the infinite possibilities of stacking, so as to meet the market demands and beneficially improve the processing yield of packages.

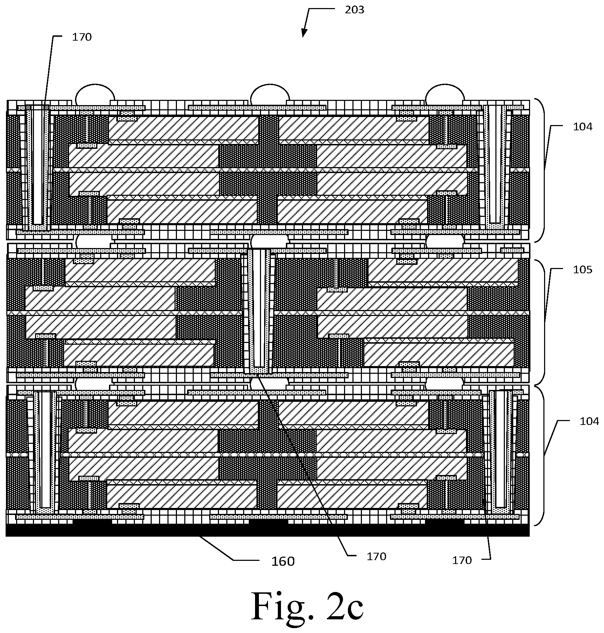

Furthermore, as shown in Fig. 2c, an embodiment is illustrated, in which an integrated package device disclosed by embodiments of the present application is made of three package modules.

In the embodiment as shown in Fig. 2c, the integrated package device in accordance with embodiments of the present application also includes multiple instances of the described package modules; the multiple package modules can be stacked in the direction, in which the first sub-package module and the second sub-package module are stacked; the external connection structure on one of any two adjacent package modules is connected with the first re-distribution layer of the other of the two adjacent package modules; the integrated package device further includes a protecting layer covering the first re-distribution layer of the package module outermost in the vertical direction; and the TMVs of the multiple package modules are aligned or misaligned in the vertical direction.

Specifically, the integrated package device 203 as shown in Fig. 2c includes two package modules 104 (each as shown in Fig. 1e) stacked one over the other vertically and one package module 105 sandwiched therebetween, all of the three package modules being stacked one on top of another in the direction, in which the first sub-package module 110 and the second sub-package module 120 of any of the package modules are stacked. The tin balls (external connection structure) 190 on the lower package module 104 act as members connected with the first re-distribution layer 130 in the package module 105 thereabove. The tin balls (external connection structure) 190 on the package module 105 act as members connected with the first re-distribution layer 130 in the package module 104 thereabove. The integrated package device 203 further includes a protecting layer 160 covering the first re-distribution layer 130 of the package module 104 outermost in the vertical direction, i.e., being located at the bottom surface of the lowermost package module 104. Furthermore, the TMVs 170 of the package modules are aligned or misaligned in the vertical direction. That is to say, the TMVs 170 in each package module 104 and the TMVs 170 in the package module 105 are misaligned, while the TMVs 170 in the uppermost package module 104 and the TMVs 170 in the lowermost package module 104 are aligned.

The integrated package device 203 as shown in Fig. 2c may achieve the same effects as the integrated package device 202 as shown in Fig. 2b. Moreover, although not shown in the figures, it can be appreciated, from the illustration of the integrated package devices 202 and 203, that any number of instances of the package modules 100, 101, 102, 103 and 104 can be used in any combination and arrangement. For example, four or even five package modules can be stacked one on top of another. And the electronic devices can also be used in any combination as described previously, for example, each vertical column may include one, two, three or four electronic devices, which means no limitation.

Based on the arbitrary combinations as described in the previous paragraphs, some embodiments of the present application further provide a memory system including an integrated package device using any of the previously described combinations, wherein at least one of the first electronic devices and/or at least one of the second electronic devices of the integrated package device include a memory device and at least any other one of the first electronic devices and/or at least any other one of the second electronic devices include a controller used to control operations of the memory device.

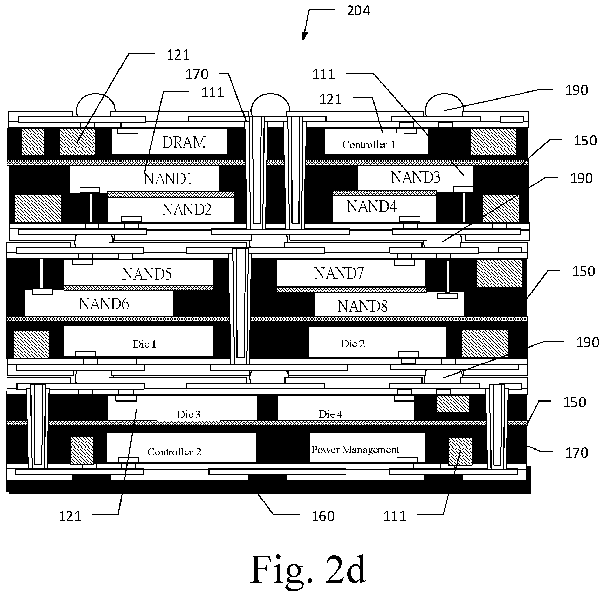

Specifically, as shown in Fig. 2d, an integrated package device 204 as a memory system is illustrated, for easy understanding, by way of a structural diagram in combination with a block diagram. In Fig. 2d, electronic devices are represented respectively by boxes with the names of corresponding devices therein and corresponding reference numbers are omitted. For example, the electronic devices represented by the boxes include a DRAM, a controller 1, NANDs 1 to 8, dies 1 to 4, a controller 2, a power management die and the like. That is to say, it can be seen at the positions corresponding to the first electronic devices in the lower first sub-package module and the second electronic devices in the upper second sub-package module of each package module as described above that the first electronic devices 111 in the integrated package device 204 as shown in Fig. 2d include NANDs 1 to 4, dies 1 to 2, a controller 2 and a power management die and the second electronic devices 121 include a DRAM, a controller 1, NANDs 5 to 8 and dies 3 to 4. Generally, the memory system includes a memory and a controller that are electrically connected, and the controller is used for controlling data storage of the memory. The memory and the controller may be those well known to the skilled persons in the art and will not be detailed here. The memory system may be applied in a computer, a television, a set top box, a vehicle-mounted terminal product or the like.

Therefore, the integrated package device 204 as shown in Fig. 2d may act as a memory system; and at least one of the first electronic devices and/or at least one of the second electronic devices in the integrated package device include a memory device and at least any other one of the first electronic devices and/or at least any other one of the second electronic devices include a controller used to control operations of the memory device.

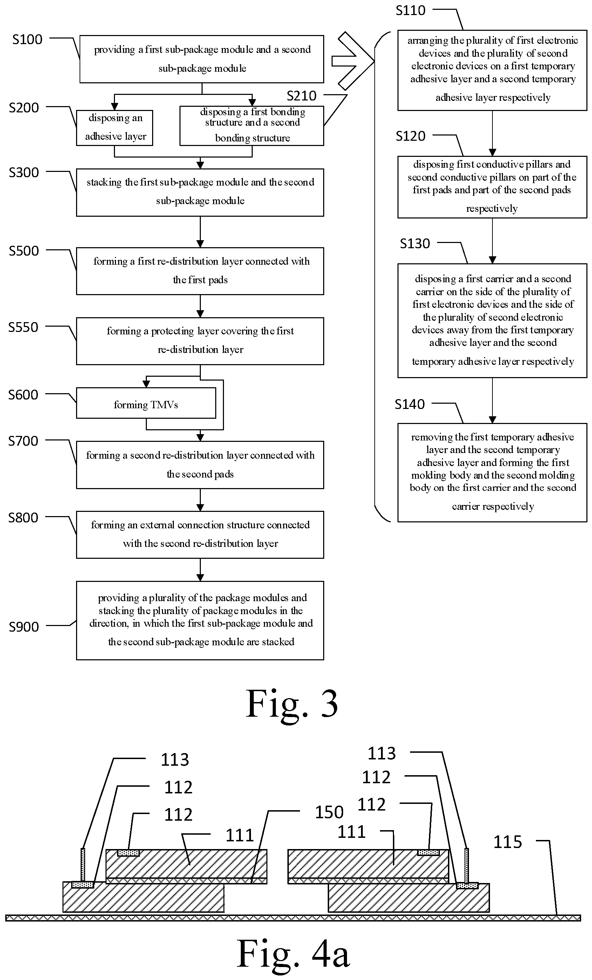

The integrated package devices in accordance with some embodiments of the present application have been described above and in accordance with some other embodiments of the present application a method of fabricating the integrated package device as described above is further provided. As shown in Fig. 3, the method of fabricating an integrated package device in accordance with some embodiments of the present application includes the following main steps:
at step S100, a first sub-package module and a second sub-package module are provided. The first sub-package module includes a plurality of first electronic devices and a first molding body encapsulating the plurality of first electronic devices, each of the first electronic devices including a first pad on a side thereof. The second sub-package module is on the side of the first sub-package module away from the first pad and includes a plurality of second electronic devices and a second molding body encapsulating the plurality of second electronic devices, each of the second electronic devices including a second pad on a side thereof;
at step S300, the first sub-package module and the second sub-package module are stacked;
at step S500, a first re-distribution layer is formed on the side of the first sub-package module away from the second sub-package module and connected with the first pads; and
at step S700, a second re-distribution layer is formed on the side of the second sub-package module away from the first sub-package module and connected with the second pads.

In the main step S 100, the first sub-package module and the second sub-package module can be provided in many ways, one of which will be taken as a representative and may further include the following sub-steps.

At step S110, the plurality of first electronic devices and the plurality of second electronic devices are arranged on a first temporary adhesive layer and a second adhesive layer respectively with the first pads of the first electronic devices and the second pads of the second electronic devices facing one and the same side respectively.

At step S120, first conductive pillars and second conductive pillars are disposed on part of the first pads and part of the second pads respectively.

At step S130, a first carrier and a second carrier are disposed on the side of the plurality of first electronic devices and the side of the plurality of second electronic devices away from the first temporary adhesive layer and the second temporary adhesive layer respectively and have temporary bonding films facing the plurality of first electronic devices and the plurality of second electronic devices respectively with the first pads and the second pads facing the first carrier and the second carrier or facing away from the first carrier and the second carrier respectively.

At step S 140, the first temporary adhesive layer and the second temporary adhesive layer are removed respectively, and the first molding body and the second molding body are formed on the first carrier and the second carrier respectively.

Likewise, in the main step S300, the first sub-package module and the second sub-package module can be stacked in many ways, one of which will be taken as a representative. That is to say, step S300 may further include: positioning the first carrier and the second carrier on two sides of the combination of the first molding body and the second molding body; and
removing the first carrier and the second carrier before forming the first re-distribution layer and the second re-distribution layer.

Likewise, between step S100 and step S300, many operations may be added depending on the chosen structure of the integrated package device and two of the operations are taken as a representative, i.e., some optional steps are included and, for example, they may include:
step S200: disposing an adhesive layer between the first sub-package module and the second sub-package module; and/or
step S210: disposing a first bonding structure and a second bonding structure on the first sub-package module and the second sub-package module respectively.

Furthermore, after forming the first re-distribution layer in step S500 and before performing step S700, many operations may be added depending on the chosen structure of the integrated package device and one of them is taken as a representative, i.e., step S550 may be optionally added, which includes forming a protecting layer on the side the first re-distribution layer away from the first sub-package module to cover the first re-distribution layer.

Furthermore, corresponding to the integrated package devices in accordance with some embodiments of the present application, for example, the integrated package device having TMVs as shown in Fig. 1c, the method of fabricating an integrated package device in accordance with some embodiments of the present application may further include the following optional steps within step S700 when the second re-distribution layer is formed:
at step S600, TMVs are formed to extend through the first molding body and the second molding body and to be connected with the first re-distribution layer and the second re-distribution layer; and the second re-distribution layer is connected with the TMVs.

Furthermore, as described in connection with the integrated package devices in accordance with some embodiments of the present application, the method of fabricating an integrated package device in accordance with some embodiments of the present application may include many ways of applying the completed basic package module, one of which is taken as a representative, i.e., the fabrication method may further include the following optional steps for application:
at step S800, an external connection structure is formed on the side of the second re-distribution layer away from the second sub-package module and connected with the second re-distribution layer; and
at step S900, a plurality of package modules are provided and stacked in the direction, in which the first sub-package module and the second sub-package module are stacked; and the external connection structure on one of any two adjacent package modules is connected with the first re-distribution layer of the other of the two adjacent package modules.

Hereafter, specifically, related steps corresponding to various possible operations in the method of fabricating an integrated package device in accordance with some embodiments of the present application will be detailed with reference to the cross-sectional structural diagrams in Figs. 4a to 4j.

At first, with reference to Figs. 4a to 4c, step S100 in Fig. 3 is performed, i.e., a first sub-package module and a second sub-package module are provided. The first sub-package module includes a plurality of first electronic devices and a first molding body encapsulating the plurality of first electronic devices, each of the first electronic devices including a first pad on a side thereof. The second sub-package module is on the side of the first sub-package module away from the first pad and includes a plurality of second electronic devices and a second molding body encapsulating the plurality of second electronic devices, each of the second electronic devices including a second pad on a side thereof.

Herein, the first sub-package module and the second sub-package module may have combinations of the same electronic devices or different electronic devices as shown in Figs. 1a and 1b, but may be fabricated using essentially the same method. Therefore, in the following description, the combination as shown in Fig. 1a may be taken as a representative for illustration and only the first sub-package module 110 will be described as a representative with the description of the devices of the second sub-package module affixed in parentheses unless it is necessary to describe the second sub-package module 120 at the same time.

Specifically, step S100 includes sub-steps S110 to S140. As shown in Fig. 4a, step S110 in Fig.3 is performed, i.e., the plurality of first electronic devices 111 (and the plurality of second electronic devices) are firstly arranged on a first temporary adhesive layer 115 (and a second temporary adhesive layer) respectively with the first pads 112 on the first electronic devices 111 (and the second pads on the second electronic devices) facing the same side respectively. The plurality of first electronic devices 111 stacked vertically may be fixed together with DAFs 150 or any suitable adhesive materials therebetween, which, however, means no limitation.

Subsequently, also as shown in Fig. 4a, step S120 is performed, i.e., first conductive pillars 113 (and second conductive pillars) protruding in the direction, in which the first electronic devices 111 are stacked, are disposed respectively on part of the first pads 112 (and part of the second pads).

Herein, in accordance with the integrated package devices in some embodiments of the present application as shown in Figs. 1a and 1b, this step is not limited to disposing conductive pillars and gold wires may be disposed depending on designs. Therefore, any devices for leading out of pads may be used. However, it can be appreciated that conductive pillars have the advantage of saving lateral space.

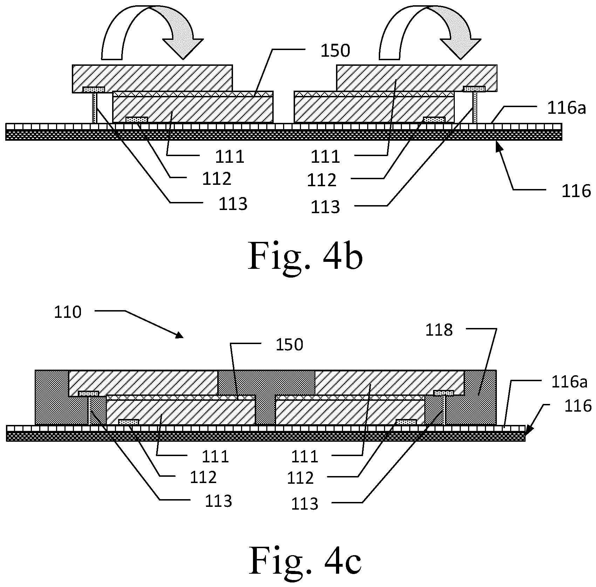

Subsequently, as shown in Fig. 4b, step S130 of Fig. 3 is performed, i.e., a first carrier 116 (and a second carrier) is disposed respectively on the side of the plurality of first electronic devices 111 (and the plurality of second electronic devices) away from the first temporary adhesive layer 115 (and the second temporary adhesive layer) and has a temporary bonding film 116a facing respectively the plurality of first electronic devices (and the plurality of second electronic devices) with the first pads 112 (and the second pads respectively) facing the first carrier 116 (and the second carrier).

Specifically, as shown in Fig. 4b, before the first electronic devices 111 are disposed on the first carrier 116, the stacked plurality of first electronic devices 111 may be inverted upside down and the first electronic device 111 not adhered to the first temporary adhesive layer 115 may be adhered to the temporary bonding film 116a of the first carrier 116. Of course, it can be appreciated that whether or not to invert the first electronic devices 111 upside down can be determined depending on the manner, in which the first pads 112 are connected with the temporary film 116a. For example, when connections are achieved through gold wires 113' as shown in Fig. 1b, it is not necessary to invert the plurality of first electronic devices 111 upside down. Alternatively, the first carrier 116 may be attached to the side of the first electronic devices away from the first temporary adhesive layer 115 directly without the inversion, and then the inversion is done to move on to the next step.

Subsequently, as shown in Figs. 4b and 4c, step S140 in Fig. 3 is performed, i.e., the first temporary adhesive layer 115 (and the second temporary adhesive layer) is respectively removed and the first molding body 118 (and the second molding body) is respectively formed on the first carrier 116 (and the second carrier) to complete the first sub-package module 110 (and the second sub-package module). The material of the molding body has been described above and will not be repeated here.

After the first sub-package module and the second sub-package module are completed respectively using the sub-steps above, the above-mentioned step S100 of providing the first sub-package module and the second sub-package module is done.

Subsequently, the above-mentioned main step S300 of stacking the first sub-package module and the second sub-package module is performed.

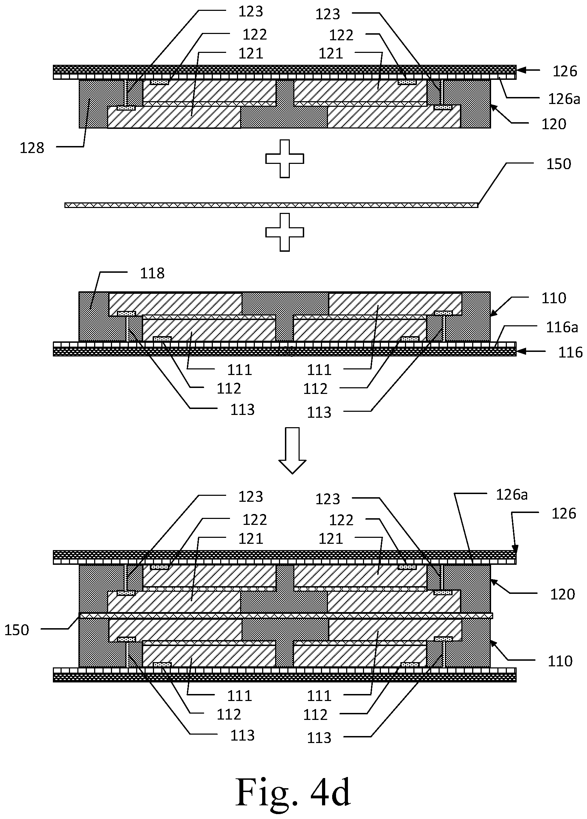

Specifically, with reference to Fig. 4d, to stack the first sub-package module and the second sub-package module, the side of the first sub-package module 110 and the side of the second sub-package module 120 away from the first carrier 116 and the second carrier 126 respectively are placed close to each other with the first carrier 116 and the second carrier 126 located on the two outer sides of the combination of the first sub-package module 110 and the second sub-package module 120.

Herein, in accordance with some embodiments of the present application, different alternative steps may be used to stack the first sub-package module and the second sub-package module depending on different structures of the integrated package device.

With respect to the first type of the steps, as shown in Fig. 4d, step S200 in Fig. 3 is performed, i.e., a DAF 150 is disposed between the first sub-package module 110 and the second sub-package module 120 to join them together solidly from upside and downside respectively.

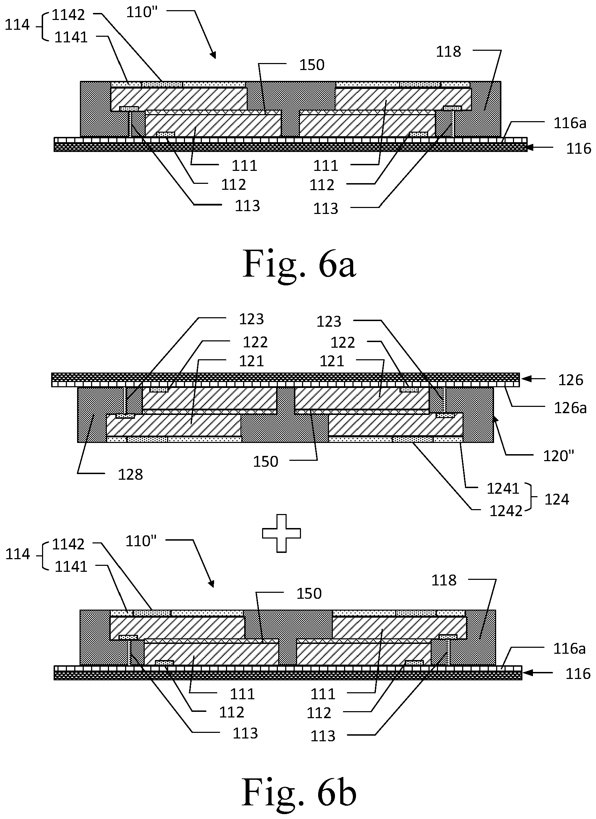

With respect to the second type of the steps, as shown in Figs. 6a and 6b, step S210 in Fig. 3 is performed, i.e., the first bonding structure 114 and the second bonding structure 124 are disposed on the bonding surfaces of the electronic devices on the bonding side of the first sub-package module 110" and the bonding side of the second sub-package module 120" respectively to bond the first sub-package module 110" and the second sub-package module 120" together and achieve conductive connections by joining the first bonding structure 114 and the second bonding structure 124 under heat or pressure. Herein, the bonding techniques are not innovated by the present application and can be known from related arts by those skilled in the art. As a result, they will not be detailed here.

After the first sub-package module and the second sub-package module are bonded together to form a combination, the main step S500 is performed. At step S500, the first re-distribution layer 130 is formed on the side of the first sub-package module 110 away from the second sub-package module 120 and connected with the first pads 112. However, before formation of the first re-distribution layer 130, the first carrier 116 is removed; and before subsequent formation of the second re-distribution layer 140, the second carrier 126 is also removed.

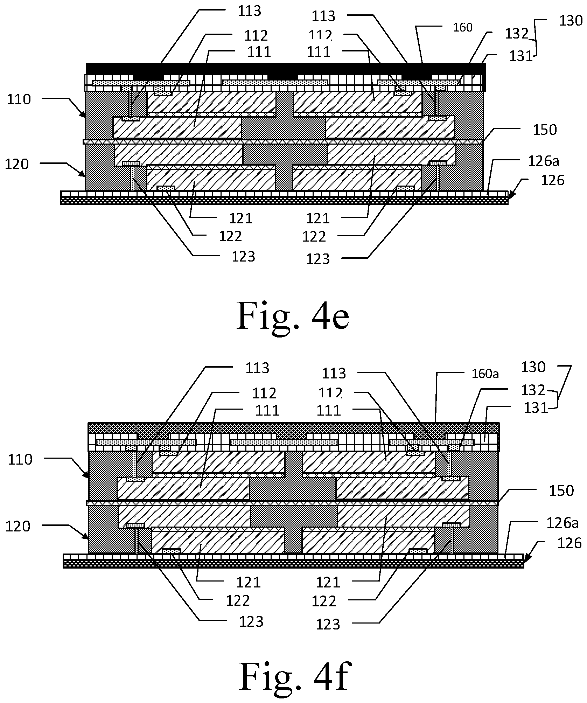

Specifically, as shown in Figs. 4e and 4f, step S500 in Fig. 3 is performed, i.e., the first carrier 116 is removed before formation of the first re-distribution layer 130 and then the first re-distribution layer 130 is formed at the location where the first carrier was before being removed. During formation of the first re-distribution layer 130, with reference to the description above, an insulating layer 131 is formed, then a conductive layer 132 is formed and then another insulating layer 131 is formed covering the conductive layer 132; and openings (not labeled) are formed at suitable positions for external connections. The conductive layer 132 may include metal, any other suitable conductive material or any combination thereof and the insulating layers 131 may include an organic or inorganic material, such as silicon oxide, silicon nitride, silicon oxynitride, any other suitable insulating material or any combination thereof. The number of the conductive layer(s) 132 and the number of the insulating layers 131 in the first re-distribution layer 130 may be determined depending on practical designs and for convenience only one conductive layer 132 is shown, which, however, means no limitation.

Subsequently, also with reference to Figs. 4e and 4f, step S550 in Fig. 3 is performed, i.e., a protecting layer 160/160a is formed on the side of the first re-distribution layer 130 away from the first sub-package module 110 to cover the first re-distribution layer 130.

Specifically, Fig. 4e and Fig. 4f are different from each other in that Fig. 4e shows a protecting layer 160 and Fig. 4f shows a temporary protecting layer 160a. The protecting layer 160 and the temporary protecting layer 160a are collectively referred to as protecting layers and may be chosen for use depending on the subsequent application of the package module. That is to say, if the first re-distribution layer 130 is outermost in the stack of package modules to be formed subsequently, as shown in Fig. 4e, the same material as that of the first molding body 118 may be used for the protecting layer; or if the first re-distribution layer 130 is in middle of the stack of package modules, as shown in Fig. 4f, the temporary protective layer 160a may be used that is easy to remove and has a material common in the art, for example but not limited to, any combination of any of polyimide, polybenzoxazole, phenol and other resins. When a package module is to be arranged in a stack with other package modules, the temporary protecting layer 160a can be removed to facilitate electrical connections of the first re-distribution layer 130 with other devices. It can be appreciated that the temporary protecting layer 160a can be or not be disposed optionally.

Subsequently, step S700 is performed, the second re-distribution layer is formed on the side of the second sub-package module away from the first sub-package module and connected with the second pads.

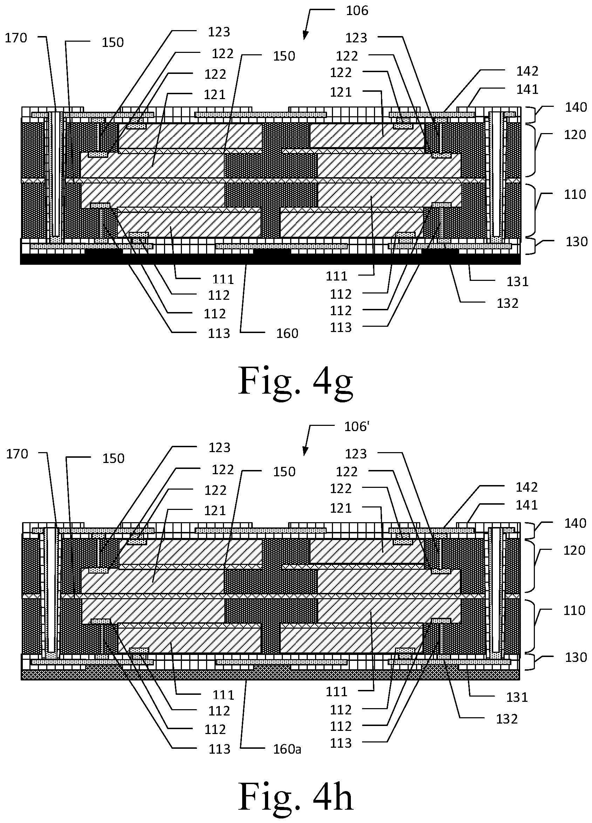

Specifically, as shown in Figs. 4g and 4h, after formation of the first re-distribution layer 130, the combination of the first sub-package module 110 and the second sub-package module 120 is inverted upside down and the second re-distribution layer 140 is formed on the side of the second sub-package module 120 away from the first sub-package module 110 and connected with the second pads 122. In order to reduce the number of figures, the optional TMVs 170 with respect to step S600 are also shown in Figs. 4g and 4h. The difference between Figs. 4g and 4h is the same as that between Figs. 4e and 4f and caused by protecting layers 160 and 160a. Likewise, before formation of the second re-distribution layer 140, the corresponding second carrier 126 is removed and the second re-distribution layer 140 is formed at the location where the second carrier 126 was before being removed. The manner and the material for forming the second re-distribution layer 140 may be similar to those for forming the first re-distribution layer 130, and will not be repeated here. So far, the basic unit of the integrated package device disclosed in embodiments of the present application, i.e., one package module 106/106', has been completed.

It is to be noted that, for different designs, as an option, the TMVs 170 corresponding to step S600 may be selectively formed at the same time as the second re-distribution layer 140. That is to say, if the bonding structures 114/124 as previously shown in Figs. 6a and 6b are formed, the TMVs 170 may be or not be implemented optionally, and even if no bonding structures are formed, the TMVs 170 are not necessarily disposed.

Specifically, as shown in Figs. 4g and 4h, before formation of two insulating layers 141, through molding openings (not labeled) are formed in the first sub-package module 110 and the second sub-package module 120 and, during formation of one insulating layer 141, the material of the insulating layer 141 is also filled into the through molding openings. Then, during formation of the conductive layer 142 and the subsequent overlying insulating layer 141 in the second re-distribution layer 140, the materials of the conductive layer 142 and the insulating layer 141 are also filled into the TMVs, so that the TMVs 170 are formed in coordination with the second re-distribution layer 140. The same as the insulating layer 131, the insulating layer 141 is used to cover the conductive layer 142 and has openings (not labeled) that are disposed at suitable positions and used to dispose tin balls 190 for external connections.

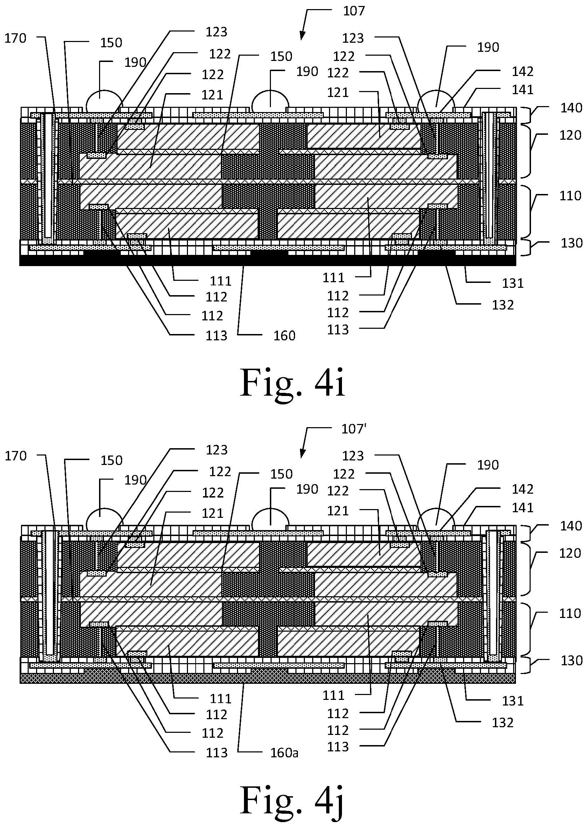

Subsequently, as shown in Figs. 4i and 4j, after formation of the first re-distribution layer 130 and the second re-distribution layer 140, step S800 is performed optionally, i.e., an external connection structure is formed on the side of the second re-distribution layer 140 away from the second sub-package module and connected with the second re-distribution layer.

Specifically, as shown in Figs. 4i and 4j, the external connection structure 190, for example, the tin balls 190, are filled into the openings (not labeled) in the insulating layer 141 of the second re-distribution layer 140. This step is optional because the package module 106/106' completed at step S700 may serve as an integrated package device alone and the tin balls may be added by the user when using the integrated package device having a single package module.

Hereafter, the method of fabricating an integrated package device including a plurality of package modules disclosed in embodiments of the present application will be described. That is to say, step S900 is performed, wherein a plurality of package modules are provided and stacked in the direction, in which the first sub-package module and the second sub-package module are stacked; and the external connection structure on one of any two adjacent package modules is connected with the first re-distribution layer of the other of the two adjacent package modules.

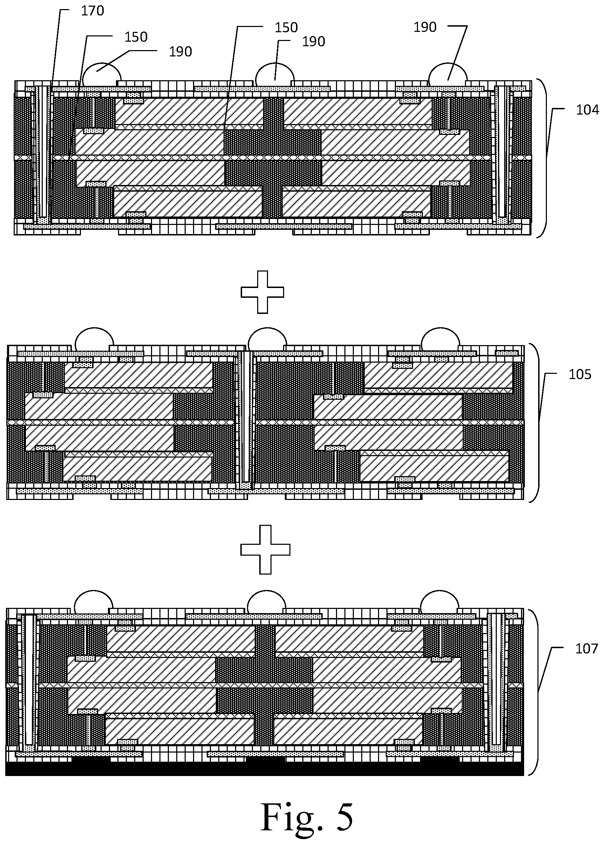

Specifically, as shown in Fig. 5, step S900 in Fig. 3 is performed, i.e., package modules such as those represented by any of the package modules 104, 105 and 107 as shown in Fig. 1e, Fig. 1f and Fig. 4i respectively are stacked one on top of another and tin balls 190 are heated to melt and then flattened, so that the integrated package device 203 as shown in Fig. 2c may be obtained after reflow and curing.

Using the method of fabricating an integrated package device described above in some embodiments of the present application, an integrated package device is provided that provides convenience and adapts to various system packages, especially those including memories. The integrated package device integrates chips of various functions, including a processor, a memory or any other functional chips, into one package to realize a substantially complete function and form a system in a package (SiP). Furthermore, the difficulty of processing ultra-thin chips for a high stack package having a high capacity may be reduced to facilitate mass production and packages of different capacities may be processed flexibly due to the infinite possibilities of stacking, so as to meet the market demands and beneficially improve the processing yield of packages.

In summary, the integrated package device, the method of fabricating an integrated package device and the memory system in some embodiments of the present application have been described above, however the present application is not defined by those embodiments. Alternations and modifications may be made to the embodiments above by those skilled in the art to obtain other embodiments without departing from the scope and spirit of the present application. All the technical solutions formed by identical or equivalent substitutions fall within the scope of the present application. Therefore, the scope of this application is defined by the claims.

## Claims

1. An integrated package device comprising at least one package module, each package module comprising:
a first sub-package module comprising a plurality of first electronic devices and a first molding body encapsulating the plurality of first electronic devices, and each of the first electronic devices including a first pad on a side thereof;
a second sub-package module stacked on a side of the first sub-package module away from the first pad and comprising a plurality of second electronic devices and a second molding body encapsulating the plurality of second electronic devices, each of the second electronic devices including a second pad on a side thereof;
a first re-distribution layer located on a side of the first sub-package module away from the second sub-package module and connected with each of the first pads; and
a second re-distribution layer located on a side of the second sub-package module away from the first sub-package module and connected with each of the second pads.

2. The integrated package device of claim 1, wherein each package module further comprising:
a through molding via (TMV) extending through the first molding body and the second molding body and connecting the first re-distribution layer and the second re-distribution layer.

3. The integrated package device of claim 1, further comprising: a first bonding structure and a second bonding structure located between the first sub-package module and the second sub-package module and respectively on the first sub-package module and the second sub-package module, the first bonding structure and the second bonding structure bonding the first sub-package module and the second sub-package module together.

4. The integrated package device of claim 1, 2 or 3, further comprising:
an external connection structure located on a side of the second re-distribution layer away from the second sub-package module and connected with the second re-distribution layer.

5. The integrated package device of claim 4, wherein the external connection structure comprises an array of tin balls.

6. The integrated package device of claim 1, 2 or 3, further comprising a protecting layer covering a side of the first re-distribution layer away from the first sub-package module.

7. The integrated package device of claim 2, further comprising an adhesive layer located between the first sub-package module and the second sub-package module.

8. The integrated package device of claim 1, wherein the plurality of first electronic devices and/or the plurality of second electronic devices are stacked, in staircase, respectively in a direction, in which the first sub-package module and the second sub-package module are stacked, and the first pad of each of the first electronic devices and/or the second pad of each of the second electronic devices are/is not covered by any other of the first electronic devices and/or any other of the second electronic devices.

9. The integrated package device of claim 1 or 8, wherein outer connecting surfaces of the first pads and outer connecting surfaces of the second pads face the first re-distribution layer and the second re-distribution layer respectively, and the first sub-package module and/or the second sub-package module further respectively comprise first conductive pillars and/or second conductive pillars, which connect the first re-distribution layer with part of the first pads and/or the second redistribution layer with part of the second pads respectively.

10. The integrated package device of claim 1, wherein outer connecting surfaces of the first pads face away from the first re-distribution layer or outer connecting surfaces of the second pads face away from the second re-distribution layer, and the package module further comprises gold wires, through which the first pads are connected with the first re-distribution layer or the second pads are connected with the second re-distribution layer.

11. The integrated package device of claim 2, wherein the plurality of first electronic devices and the plurality of second electronic devices are arranged respectively in at least two columns of electronic devices in a lateral direction perpendicular to a direction, in which the first sub-package module and the second sub-package module are stacked; and the TMV is located on an outer side of one column of the electronic devices away from the other column, and there is at least one TMV

12. The integrated package device of claim 2, wherein the plurality of first electronic devices and the plurality of second electronic devices are arranged respectively in at least two columns of the electronic devices in a lateral direction perpendicular to a direction, in which the first sub-package module and the second sub-package module are stacked; and the TMV is located between the two columns of the electronic devices, and there is at least one TMV

13. The integrated package device of claim 4, comprising a plurality of the package modules, wherein the plurality of the package modules are stacked in a direction, in which the first sub-package module and the second sub-package module are stacked, and wherein the external connection structure on one of any two adjacent package modules is connected with the first re-distribution layer of the other of the two adjacent package modules; and the integrated package device further comprises a protecting layer covering the first re-distribution layer of the package module outermost in a vertical direction.

14. The integrated package device of claim 2, wherein the package module further comprises an external connection structure located on a side of the second re-distribution layer away from the second electronic devices and connected with the second re-distribution layer; and
the integrated package device further comprises:
a plurality of the package modules that are stacked in a direction, in which the first sub-package module and the second sub-package module are stacked, and wherein,
the external connection structure on one of any two adjacent package modules is connected with the first re-distribution layer of the other of the two adjacent package modules;
the integrated package device further comprises a protecting layer covering the first re-distribution layer of the package module outermost in a vertical direction; and
the TMVs in the package modules are aligned or misaligned in the vertical direction.

15. A method of fabricating an integrated package device, comprising:
providing a first sub-package module and a second sub-package module, the first sub-package module comprising a plurality of first electronic devices and a first molding body encapsulating the plurality of first electronic devices, each of the first electronic devices including a first pad on a side thereof, and the second sub-package module being on a side of the first sub-package module away from the first pad, and comprising a plurality of second electronic devices and a second molding body encapsulating the plurality of second electronic devices, each of the second electronic devices including a second pad on a side thereof;
stacking the first sub-package module and the second sub-package module;
forming a first re-distribution layer located on a side of the first sub-package module away from the second sub-package module and connected with the first pads; and
forming a second re-distribution layer located on a side of the second sub-package module away from the first sub-package module and connected with the second pads.

16. The method of fabricating an integrated package device of claim 15, wherein forming the second re-distribution layer connected with the second pads further comprises forming a through molding via (TMV) that extends through the first molding body and the second molding body and connects the first re-distribution layer and the second re-distribution layer; and the second re-distribution layer is connected with the TMV

17. The method of fabricating an integrated package device of claim 15 or 16, further comprising: forming an external connection structure on a side of the second re-distribution layer away from the second sub-package module and connected with the second re-distribution layer.

18. The method of fabricating an integrated package device of claim 15, wherein providing the first sub-package module and the second sub-package module comprises:
arranging the plurality of first electronic devices and the plurality of second electronic devices on a first temporary adhesive layer and a second temporary adhesive layer respectively with outer connecting surfaces of the first pads of the first electronic devices and outer connecting surfaces of the second pads of the second electronic devices facing one and the same side;
disposing a first carrier and a second carrier on a side of the plurality of first electronic devices and a side of the plurality of second electronic devices away from the first temporary adhesive layer and the second temporary adhesive layer respectively, the first carrier and the second carrier including temporary bonding films facing the plurality of first electronic devices and the plurality of second electronic devices respectively, and the outer connecting surfaces of the first pads and the outer connecting surfaces of the second pads facing the first carrier and the second carrier respectively or facing away from the first carrier and the second carrier respectively; and
removing the first temporary adhesive layer and the second temporary adhesive layer respectively and forming the first molding body and the second molding body on the first carrier and the second carrier respectively.

19. The method of fabricating an integrated package device of claim 18, further comprising: before disposing the first carrier and the second carrier, disposing first conductive pillars and second conductive pillars on part of the first pads and part of the second pads respectively.

20. The method of fabricating an integrated package device of claim 15, wherein stacking the first sub-package module and the second sub-package module further comprises: disposing an adhesive layer between the first sub-package module and the second sub-package module.

21. The method of fabricating an integrated package device of claim 15, wherein stacking the first sub-package module and the second sub-package module further comprises: disposing a first bonding structure and a second bonding structure on the first sub-package module and the second sub-package module respectively.

22. The method of fabricating an integrated package device of claim 15, further comprising: forming a protecting layer on a side of the first re-distribution layer away from the first sub-package module to cover the first re-distribution layer.

23. The method of fabricating an integrated package device of claim 18, further comprising:
during stacking of the first sub-package module and the second sub-package module, placing a side of the first sub-package module and a side of the second sub-package module away from the first carrier and the second carrier respectively close to each other with the first carrier and the second carrier located on the two outer sides of a combination of the first sub-package module and the second sub-package module; and
removing the first carrier and the second carrier respectively before forming the first re-distribution layer and the second re-distribution layer.

24. The method of fabricating an integrated package device of claim 17, further comprising: providing a plurality of the package modules; stacking the plurality of the package modules in a direction, in which the first sub-package module and the second sub-package module are stacked; and connecting the external connection structure on one of any two adjacent package modules with the first re-distribution layer of the other of the two adjacent package modules.

25. The method of fabricating an integrated package device of claim 24, wherein stacking the plurality of the package modules in the direction, in which the first sub-package module and the second sub-package module are stacked, further comprises: forming a protecting layer located on and covering the first re-distribution layer of the package module outermost in a vertical direction.

26. A memory system, comprising:
the integrated package device of any one of claims 1 to 14,
wherein at least one of the first electronic devices and/or at least one of the second electronic devices in the integrated package device comprise/comprises a memory device and at least any other one of the first electronic devices and/or at least any other one of the second electronic devices comprise/comprises a controller to control operations of the memory device.
